Europäisches Patentamt

European Patent Office

Office européen des brevets

(19)

(11) **EP 1 067 692 A1**

(12) **DEMANDE DE BREVET EUROPEEN**

(43) Date de publication:
**10.01.2001 Bulletin 2001/02**

(51) Int Cl.⁷: **H03K 19/00**

(21) Numéro de dépôt: **00401951.9**

(22) Date de dépôt: **06.07.2000**

(84) Etats contractants désignés:
**AT BE CH CY DE DK ES FI FR GB GR IE IT LI LU
MC NL PT SE**
Etats d'extension désignés:
**AL LT LV MK RO SI**

(30) Priorité: **08.07.1999 FR 9908866**

(71) Demandeur: **C.S.E.M. CENTRE SUISSE
D'ELECTRONIQUE ET DE MICROTECHNIQUE
SA
2007 Neuchâtel (CH)**

(72) Inventeur: **Piguet, Christian
2000 Neuchâtel (CH)**

(74) Mandataire: **Caron, Gérard et al
CABINET DE BOISSE,
L.A. DE BOISSE - J.P. COLAS,
37 avenue Franklin D. Roosevelt
75008 Paris (FR)**

(54) **Circuit logique adiabatique**

(57)     Ce circuit logique adiabatique comprend des organes bidirectionnels de transfert (3, 4) auxquels sont appliqués les variables d'entrée (A, B, C, $\bar{A}$, $\bar{B}$, $\bar{C}$) du circuit et qui sont connectés entre une première borne (5) destinée à être raccordée à un générateur d'horloge ($\phi$) dont le signal d'horloge assure en même temps l'alimentation du circuit, et une deuxième borne (6) formant sa sortie et pouvant, en fonction desdites variables d'entrée, être portée à deux niveaux logiques, le circuit comprenant également une troisième borne (7i) connectée à la seconde borne (6) par l'intermédiaire de la capacité propre (8) de celle-ci.

Selon l'invention des moyens de précharge (9) sont connectés à la deuxième borne (6) pour la précharger à un potentiel correspondant à l'un des niveaux logiques, en dehors des phases actives du signal d'horloge ($\phi$).

FIG.:2

Printed by Jouve, 75001 PARIS (FR)

**Description**

La présente invention est relative aux circuits logiques adiabatiques.

Des circuits logiques de ce type ont été décrits, notamment dans un ouvrage de C. Piguet, intitulé "Circuits Complexes - Evolution de la technologie VLSI, extrait des cours sur les circuits complexes de l'Ecole Polytechnique Fédérale de Lausanne, Suisse, 1998, chapitre 6, et dans un article de L.J. Svensson et al. intitulé "Driving a capacitive load without dissipating $fCV^2$", IEEE Symposium on Low Power Electronics, pp. 100 et 101, 1994.

Ces circuits ont l'avantage de réduire la consommation selon la formule:

$$E = \frac{\tau}{T} CVdd^2$$

dans laquelle $\square$ est un délai interne du circuit, C la capacité interne et T le temps de montée du signal d'horloge qui joue en même temps le rôle d'alimentation, $V_{dd}$ étant le potentiel de l'un des niveaux logiques possibles pouvant être assumés par les variables d'entrée et de sortie du circuit.

Pour qu'un circuit logique adiabatique puisse fonctionner, il faut que les variables d'entrée qui lui sont appliquées soient parvenues à leur niveau logique stable avant que le signal d'horloge ne transite. Ceci pose un problème ardu, lorsque plusieurs circuits logiques adiabatiques sont mis en cascade, la sortie d'un circuit constituant alors l'une des variables d'entrée d'une porte suivante. Le signal d'horloge d'un second circuit ne peut alors transiter avant que le signal de sortie du circuit précédent soit arrivé à se stabiliser. Il faut donc avoir recours à des signaux d'horloge imbriqués, provenant de ce qu'il est convenu d'appeler une horloge "cascade rétractile". Les signaux d'entrée étant, en général, d'une part sous la forme vraie et la forme complémentée, et d'autre part devant être valide avant la montée du signal d'horloge, il est nécessaire pour le circuit adiabatique qu'il puisse délivrer son signal de sortie à la fois sous la forme vraie et sous la forme complémentée.

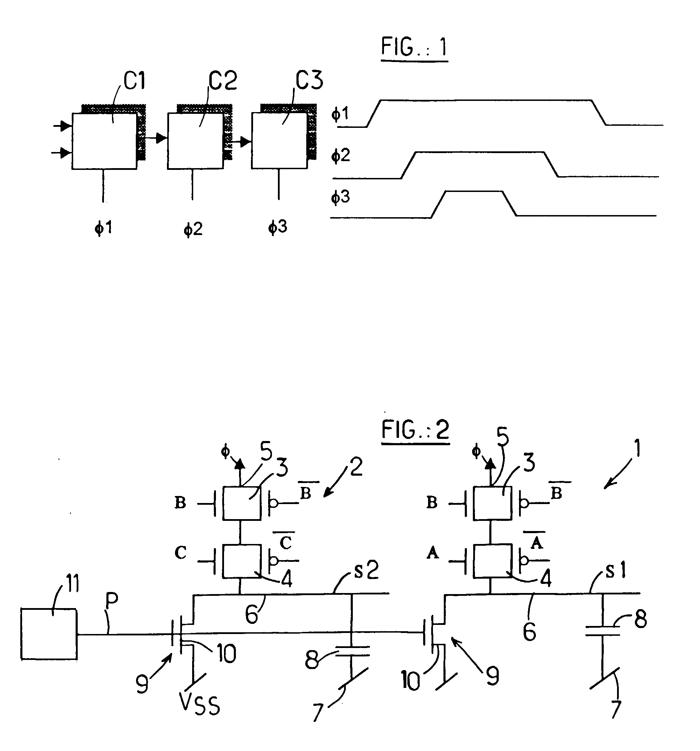

La figure 1 des dessins annexés illustre ce concept. Ici, les circuits logiques adiabatiques C1, C2 et C3 sont montés en cascade et leurs horloges $\phi$1, $\phi$2 et $\phi$3 transient respectivement de façon rétractile, comme le montrent les signaux de la figure 1.

Un générateur d'horloge permettant d'engendrer ce type de signaux d'horloge est complexe et délicat à mettre en oeuvre, surtout si la "profondeur logique" est importante, c'est-à-dire lorsque de nombreux circuits logiques sont mis en cascade.

Néanmoins certains circuits, comme des PLA (Programmable Logic Arrays) ou des mémoires ROM, ne comportent que deux portes logiques en série; ce qui correspond à une "profondeur logique" égale à 2 et, donc, ne requiert que deux signaux d'horloge.

L'invention a pour but de fournir un circuit logique de type adiabatique, qui utilise un mécanisme de précharge en vue de réduire le nombre nécessaire de transistors.

Elle a donc pour objet un circuit logique adiabatique comprenant les caractéristiques définies dans la revendication 1.

D'autres caractéristiques de ce circuit logique adiabatique sont définies dans les sous-revendications 2 à 4.

L'invention a également pour objet un circuit de mémoire adressable, tel que défini dans la revendication 5.

D'autres caractéristiques de ce circuit de mémoire adressable sont définies dans les revendications 6 à 11.

D'autres caractéristiques et avantages de l'invention apparaîtront au cours de la description qui va suivre, donnée uniquement à titre d'exemple et faite en se référant aux dessins annexés sur lesquels:

- la figure 1, déjà décrite, est une illustration d'un montage en cascade de circuits adiabatiques selon la technique antérieure;
- les figures 2, 3 et 4 représentent chacune un exemple de réalisation d'une paire de circuits logiques adiabatiques selon l'invention, avec chaque fois une fonction logique différente;
- la figure 5 est une table de vérité d'un circuit de mémoire dans lequel des portes logiques adiabatiques selon l'invention peuvent être incorporées;
- la figure 6 est un schéma de base d'un tel circuit de mémoire;
- la figure 7 montre un premier mode de réalisation d'un circuit de mémoire adiabatique selon l'invention;
- la figure 8 est un diagramme des temps illustrant les signaux de commande du circuit de mémoire de la figure 7; et
- les figures 9 à 11 montrent trois autres modes de réalisation selon l'invention.

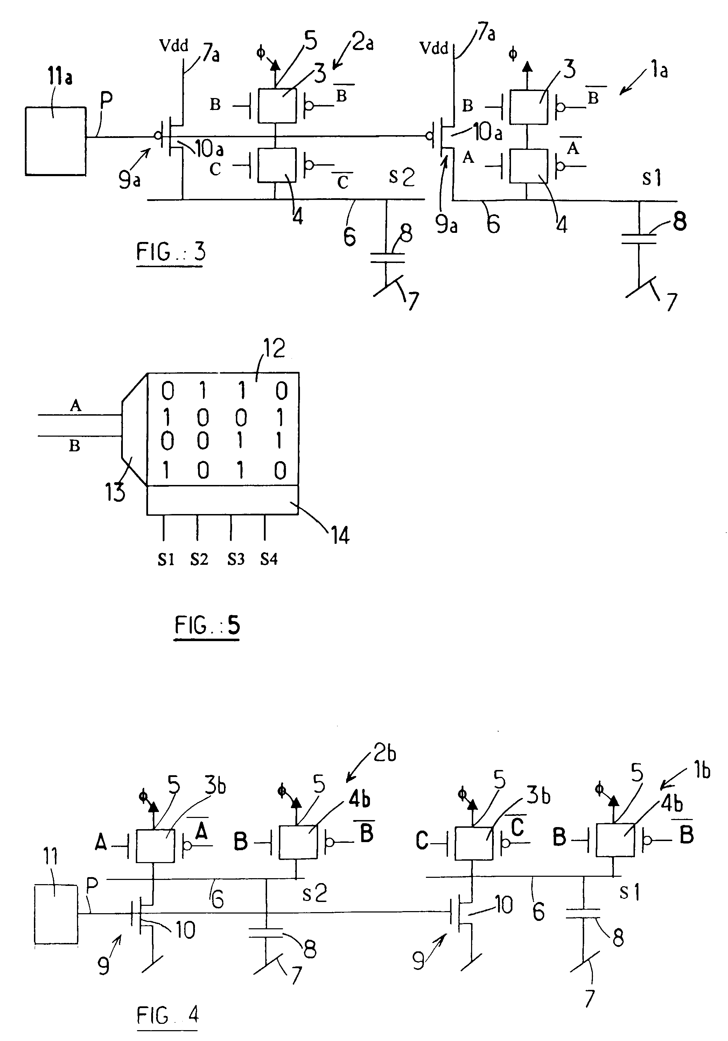

Le premier mode de réalisation du circuit logique adiabatique, représenté à la figure 2, concerne deux portes ET 1 et 2 connectées en parallèle et formant chacune un circuit adiabatique selon l'invention.

Chaque porte ET comprend deux organes bidirectionnels de transfert 3 et 4, formés en l'occurrence par deux transistors n en série mis en parallèle à deux transistors p en série. Des variables d'entrée A, B et C et leurs valeurs complémentaires $\bar{A}$, $\bar{B}$ et $\bar{C}$ sont appliquées respectivement sur les grilles des transistors de ces organes de transfert, comme représenté sur la figure 2. Par ailleurs, ces derniers sont raccordés en série (fonction ET) entre d'une part une première borne 5 du circuit à laquelle est appliqué un signal d'horloge $\phi$, et d'autre part à une seconde borne 6 du circuit à laquelle peut être prélevée la variable de sortie S1 ou S2 de la porte en question.

Cette seconde borne 6 est reliée à une troisième borne de circuit 7 par l'intermédiaire de sa capacité propre 8, cette troisième borne étant au potentiel de l'un des niveaux logiques que peut assumer la borne de sortie en fonction des variables d'entrée. Dans le cas représenté, ce potentiel est celui de la masse ou $V_{ss}$.

Selon l'invention, chaque porte ET 1 et 2 comprend également des moyens de précharge 9 formés, dans le présent exemple, par un transistor 10 raccordé par son trajet source-drain entre les deuxième et troisième bornes du circuit. On voit que les grilles des transistors de précharge 10 sont reliées à une quatrième borne de circuit commune aux deux portes ET 1 et 2 et à laquelle peut être connecté un générateur 11 d'un signal de précharge. Si le montage comporte davantage de portes connectées en parallèle, chaque transistor de précharge pourra recevoir le même signal de précharge P.

Dans le cas représenté, la deuxième borne de chaque porte ET est préchargée à "0".

Le fonctionnement de ce circuit adiabatique est le suivant.

Lorsque la borne 5 est à "0" ($\phi$="0"), la précharge est active ("0") de sorte que S1=0 et S2=0. Les variables d'entrée A, B et C, de même que les variables complémentées $\bar{A}$, $\bar{B}$ et $\bar{C}$, sont supposées avoir acquis un niveau logique stable. La précharge P est relâchée, mais S1 et S2 restent à "0".

Puis, le signal $\phi$ provenant d'un générateur d'horloge (non représenté) monte lentement de "0" à "1". Selon les valeurs des variables d'entrée, les signaux S1 et S2 restent dynamiquement à "0" ou suivent le signal d'horloge $\phi$, les organes de transfert 3 et 4 étant alors conducteurs.

Les valeurs des sorties S1 et S2 peuvent alors être exploitées. Puis, le signal $\phi$ est amené à descendre lentement de "1" vers "0". Les charges qui ont été accumulées auparavant sur la capacité 8 sont récupérées dans le générateur d'horloge en transitant à travers les organes de transfert 3 et 4. Puis le signal $\phi$ est de nouveau à "0" et la précharge est activée pour positionner S1 et S2 de nouveau à "0".

La figure 3 représente un second mode de réalisation dans lequel les circuits adiabatiques selon l'invention forment chacun une porte NON-ET. Par rapport au mode de réalisation de la figure 2, les éléments analogues sont ici désignés par les mêmes repères, tandis que ceux qui en diffèrent ont des repères suivis du suffixe "a".

Dans ce cas, il est prévu des moyens de précharge 9a formés par un transistor canal p raccordé entre la seconde borne 6 de la porte respective et une troisième borne 7a portée au potentiel $V_{dd}$, c'est à dire le potentiel logique opposé à celui de la troisième borne 7 du mode de réalisation de la figure 2. Comme dans ce cas les sorties des portes 1a et 2a sont à "1", le signal d'horloge $\phi$ est à "1" à l'état de repos du générateur d'horloge.

Les circuits adiabatiques de la figure 3 sont des portes NON-ET, car quand les organes de transfert 3 et 4 conduisent, la sortie S1 ou S2 suivra le signal $\phi$ lorsqu'il passera de "1" à "0", étant supposé que A=B=1. On aura donc S1 ou S2=0 pour A=B=1.

Le fonctionnement est le suivant.

Lorsque la borne 5 est à "1" ($\phi$="1"), la précharge est active ("1") de sorte que S1=1 et S2=1. Les variables d'entrée A, B et C ayant acquis un niveau logique stable, la précharge P est relâchée, mais S1 et S2 restent à "1".

Puis, le signal $\phi$ provenant du générateur d'horloge descend lentement de "1" à "0". Selon les valeurs des variables d'entrée, les signaux S1 et S2 restent dynamiquement à "1" ou suivent le signal d'horloge $\phi$, les organes de transfert étant alors conducteurs. Les charges de la capacité 8 sont récupérées dans le générateur d'horloge à travers ces organes de transfert.

Les valeurs des sorties S1 et S2 peuvent alors être exploitées. Puis, le signal $\phi$ est amené à monter lentement de "0" vers "1". Le signal $\phi$ est de nouveau à "1" et la précharge est activée pour positionner S1 et S2 de nouveau à "1".

La figure 4 montre un troisième mode de réalisation du circuit adiabatique selon l'invention dans lequel chaque circuit 1b, 2b forme une porte OU. Les moyens de précharge 9 sont ici analogues à ceux représentés sur la figure 2. Pour assurer la fonction OU, les organes de transfert 3b et 4b sont connectés en parallèle entre les première et seconde bornes 5 et 6 des circuits.

Il est à noter que les fonctions logiques des circuits adiabatiques que l'on vient de décrire peuvent être déterminées en choisissant le niveau de la précharge (transistor à canal n ou à canal p) et/ou le montage en série ou en parallèle des organes de transfert. C'est ainsi que l'on peut former une porte NON-ET en prévoyant une précharge avec un transistor à canal n et en connectant les organes de transfert en parallèle.

On va maintenant examiner plusieurs applications des circuits adiabatiques que l'on vient de décrire.

La figure 5 représente de façon simplifiée une mémoire ROM 12 comprenant un décodeur d'entrée 13 pour le décodage des variables d'entrée (adresses) A et B et un réseau de sortie 14 pour des signaux de sortie S1 à S4. Bien entendu, il s'agit d'un exemple très simplifié, une mémoire ROM pouvant avoir une capacité bien supérieure. Un exemple de table de vérité de cette mémoire est indiqué sur la figure 5.

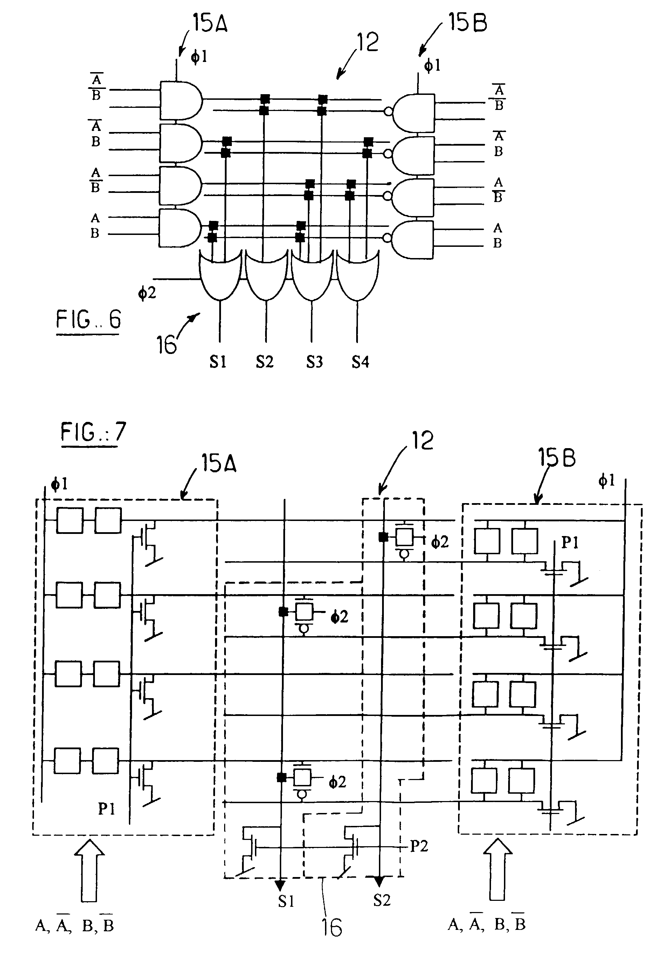

La figure 6 montre un schéma de cette mémoire ROM 12, lorsqu'elle est réalisée à l'aide des circuits adiabatiques tels que représentés sur les figures 2 à 4.

Cette mémoire 12 comprend des premier et second décodeurs 15A et 15B comprenant chacun autant de portes logiques qu'il y a de lignes de la mémoire, et un réseau de sortie 16.

Le premier décodeur 15A est formé de portes ET selon la figure 2, le deuxième décodeur 15B est formé de portes NON-ET ayant une précharge connectée au potentiel $V_{ss}$ et des organes de transfert en parallèle, le réseau de sortie 16 étant formé de portes OU conformément à la figure 4.

Comme on le voit sur la figure 4, les portes OU telles que les portes 1b et 2b nécessitent pour fonctionner des variables d'entrée vraies et complémentées. Si on souhaite réaliser une mémoire ROM complètement adiabatique, il est alors nécessaire d'engendrer sur chaque ligne de la matrice, non seulement des signaux vrais, mais également leurs compléments. Or, dans une configuration de mémoire dont il est question ici, il est très difficile, voire impossible de réaliser ces signaux par des inverseurs, qu'ils soient adiabatiques ou non. Ceci explique donc la présence des deux réseaux de décodage des variables d'adresse de la mémoire.

La figure 7 est une représentation plus détaillée de la mémoire ROM 12 de la figure 6, une simplification ayant été opérée par l'omission des sorties S3 et S4 et des conducteurs de colonne correspondants.

On voit que les portes des décodeurs 15A et 15B sont commandées par un signal d'horloge $\phi$1 et préchargées à $V_{ss}$ par un signal de précharge P1 et qu'elles constituent respectivement des portes ET selon la figure 2 et des portes NON-ET conformément à une variante, décrite précédemment, de la figure 3, toutes les portes recevant les variables A et B et leurs compléments.

Les portes OU 16 fournissant les sorties S1 et S2 sont conformes à la figure 4, leurs organes de transfert étant répartis dans la matrice de lignes et colonnes de la mémoire en fonction de la table de vérité de celle-ci (voir figure 5). Ces portes OU sont préchargées à $V_{ss}$ par un signal P2.

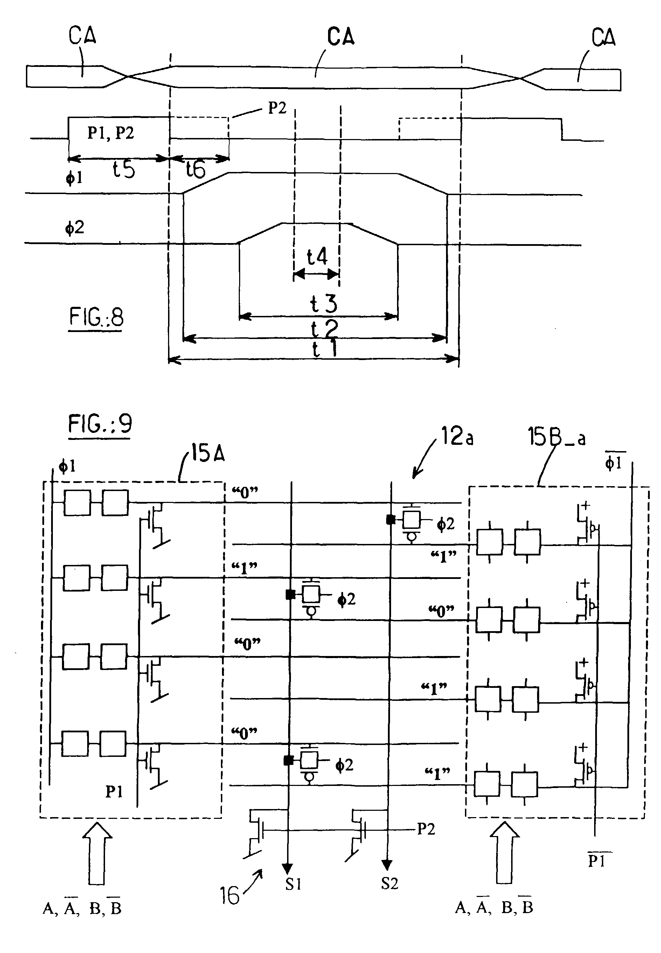

La figure 8 montre la forme des signaux qui sont appliqués à la mémoire de la figure 7 pendant un cycle de fonctionnement. Le champ d'adresse CA est maintenu actif pendant une durée t1. Les décodeurs 15A et 15B et le réseau de sortie 16 sont commandés par des signaux d'horloge rétractiles $\phi$1 et $\phi$2 ayant des durées actives distinctes t2 et t3, avec t3 < t2. En effet, les décodeurs 15A et 15B doivent être maintenus actifs pendant le temps t2, pour que les portes OU 16 puissent recevoir leurs signaux d'entrée. Les signaux de sortie des portes OU sont donc valides pendant le temps t4. Les signaux de précharge P1 et P2 peuvent être identiques et de durée t5 en transitant vers leur niveau d'inactivité au début du champ d'adresse CA. Cependant, on peut également prolonger la durée du signal de précharge P2 par l'intervalle t6, tant que le signal $\phi$2 reste à zéro.

La figure 9 montre une variante de mémoire ROM 12a dans laquelle les portes NON-ET du décodeur 15B de la figure 7 sont remplacées par des portes NON-ET, préchargées à $V_{dd}$, d'un décodeur 15B-a. Cette version implique une alimentation de ces portes avec un signal d'horloge $\overline{\phi1}$ complémentaire à $\phi$1. L'avantage

de cette version réside dans le fait que, pendant un cycle de travail de la mémoire, seules les portes du décodeur 15A devant passer à "1" transitent en suivant $\phi$1, tandis que pour ce qui concerne le décodeur 15B-a, seule la porte NON-ET devant passer à "0" transite en suivant $\overline{\phi1}$. Dans cette version, l'activité des portes des décodeurs peut donc être réduite au minimum.

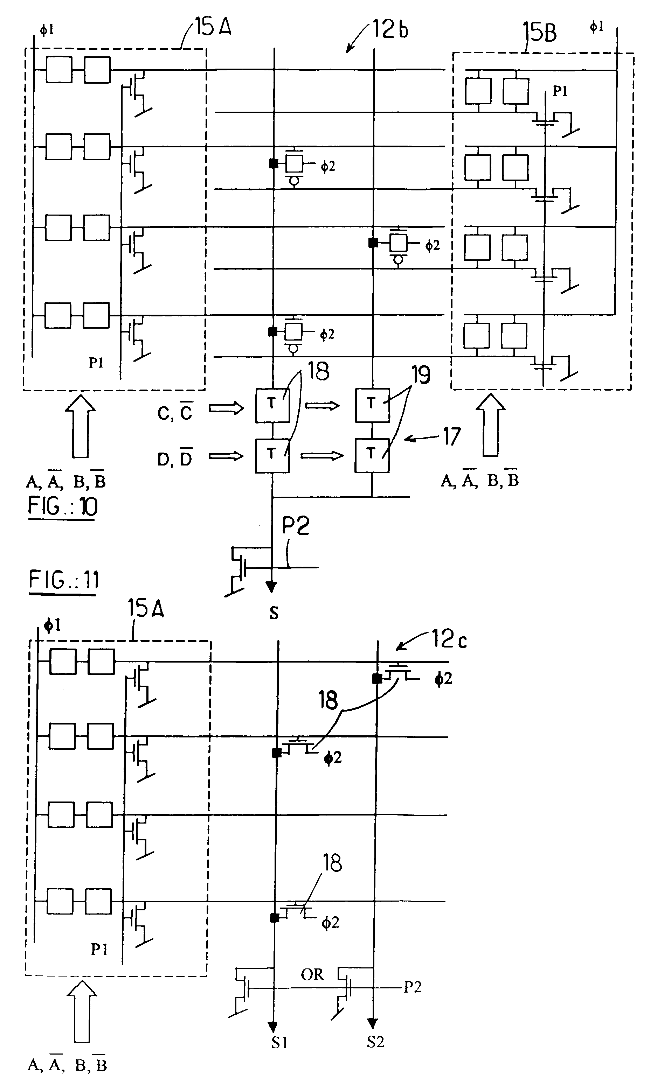

La figure 10 montre une variante de la mémoire ROM de la figure 7 dans laquelle les portes OU de sortie sont agencées en multiplexeur de sortie 17. Dans ce cas, les portes OU comprennent des organes de transfert 18 et 19 commandés par des variables C et D et leurs compléments respectifs. Ce multiplexeur est préchargé avec un signal de précharge P2.

Les variantes des figures 7 et 10 doivent comporter des moyens générateurs pour engendrer à partir des variables d'entrée (A, B, respectivement A, B, C et D) les compléments de ces mêmes variables. Ces moyens générateurs peuvent être non adiabatiques. S'ils sont adiabatiques, trois signaux d'horloge rétractiles (comme les signaux de la figure 1) seront nécessaires.

La figure 11 représente une autre variante d'une mémoire ROM qui est de type semi-adiabatique, dans laquelle les portes de transmission des portes OU de sortie ont été remplacées par des transistors canal n 18, le décodeur 15B à portes NON-ET pouvant alors être omis. On peut donc ainsi réduire considérablement le nombre total de transistors utilisés. Le trajet source-drain de ces transistors 18 est alimenté par le signal $\phi$2. Cependant, cet agencement présente une tension de sortie maximale réduite égale à $V_{dd}$-$V_t$, $V_t$ étant la tension de seuil des transistors 18. Il faut alors connecter à la sortie des composants particuliers tels que des inverseurs avec un seuil dissymétrique, par exemple.

## Revendications

1. Circuit logique adiabatique comprenant des organes bidirectionnels de transfert (3, 4 ; 3b, 4b) auxquels sont appliqués les variables d'entrée (A, B, C, $\overline{A}$, $\overline{B}$, $\overline{C}$) du circuit et qui sont connectés entre d'une part une première borne de circuit (5) destinée à être raccordée à un générateur d'horloge ($\phi$) dont le signal d'horloge assure en même temps l'alimentation du circuit, et d'autre part une deuxième borne de circuit (6) formant sa sortie et pouvant, en fonction desdites variables d'entrée, être portée à deux niveaux logiques, le circuit comprenant également une troisième borne (7i) connectée à ladite seconde borne (6) par l'intermédiaire de la capacité propre (8) de celle-ci,

caractérisé en ce qu'il comprend également des moyens pour précharger (9, 9a) ladite deuxième borne (6) à un potentiel correspondant à l'un desdits niveaux logiques, en dehors des phases actives dudit signal d'horloge ($\phi$).

**2.** Circuit logique adiabatique suivant la revendication 1, caractérisé en ce que lesdits moyens de précharge (9, 9a) comprennent un transistor (10; 10a) dont le trajet source-drain est relié entre ladite deuxième borne (6) et le potentiel de l'un desdits niveaux logiques, et en ce que ledit transistor (10; 10a) est raccordé à un générateur de signaux de précharge (11; 11a).

**3.** Circuit logique adiabatique suivant la revendication 2, caractérisé en ce que ledit transistor est à canal n (10) et en ce que ledit niveau logique est le potentiel $V_{ss}$ du circuit.

**4.** Circuit logique adiabatique suivant la revendication 2, caractérisé en ce que ledit transistor (10a) est à canal p et en ce que ledit niveau logique est le potentiel Vdd du circuit.

**5.** Circuit de mémoire adressable, caractérisé en ce qu'il comprend une matrice de lignes et de colonnes et au moins un décodeur d'adresses (15A, 15B; 15B-a) connecté auxdites lignes et comportant une pluralité de circuits logiques adiabatiques suivant l'une quelconque des revendications 1 à 6, auxquels sont appliqués des variables d'adresse pour ledit circuit de mémoire, et en ce que les moyens de précharge des circuits logiques adiabatiques du décodeur sont connectés pour recevoir le même signal de précharge (P1; $\bar{P}$ 1).

**6.** Circuit de mémoire suivant la revendication 5, caractérisé en ce qu'il comprend des premier et second décodeurs d'adresses (15A, 15B; 15B·a) dont les circuits logiques adiabatiques sont respectivement connectés auxdites lignes pour leur fournir à la fois la valeur vraie de chaque adresse et le complément de chaque valeur d'adresse.

**7.** Circuit de mémoire suivant la revendication 6, caractérisé en ce que les moyens de précharge des circuits logiques desdits décodeurs (15A, 15B) sont agencés pour précharger au potentiel d'un même niveau logique ladite deuxième borne du circuit logique dont ils font partie.

**8.** Circuit de mémoire suivant la revendication 5, caractérisé en ce que les moyens de précharge des circuits logiques de l'un (15B-a) desdits décodeurs sont agencés pour précharger les deuxièmes bornes de ces derniers à un niveau logique différent de celui auquel sont préchargés les deuxièmes bornes des circuits logiques de l'autre décodeur (15A).

**9.** Circuit de mémoire suivant l'une quelconque des revendications 5 à 8, caractérisé en ce qu'il comprend également un réseau de sortie (16) connecté auxdites colonnes et comportant une pluralité de circuits logiques adiabatiques suivant l'une quelconque des revendications 1 à 6 et en ce que les moyens de précharge des circuits logiques dudit réseau de sortie (16) sont connectés pour recevoir le même signal de précharge que les moyens de précharge des circuits logiques d'au moins un décodeur, ou éventuellement ledit signal de précharge prolongé.

**10.** Circuit de mémoire suivant la revendication 9, caractérisé en ce que ledit réseau de sortie (16) comprend un circuit logique pour chacune desdites colonnes et en ce que les organes de transfert de ces circuits sont disposés respectivement aux croisements des lignes et des colonnes de ladite matrice ou un "1" logique doit être présent.

**11.** Circuit de mémoire suivant l'une quelconque des revendications 9 et 10, caractérisé en ce que ledit réseau de sortie est agencé sous la forme d'un multiplexeur (17).

FIG.: 1

FIG.: 2

FIG.: 3

FIG.: 5

FIG.. 4

FIG.. 6

FIG.: 7

FIG.:8

FIG.:9

FIG.: 10

FIG.: 11

**Office européen des brevets**

## RAPPORT DE RECHERCHE EUROPEENNE

Numéro de la demande

EP 00 40 1951

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | YE Y ET AL: "ENERGY RECOVERY CIRCUITS USING REVERSIBLE AND PARTIALLY REVERSIBLE LOGIC" IEEE TRANSACTIONS ON CIRCUITS AND SYSTEMS I: FUNDAMENTAL THEORY AND APPLICATIONS,US,IEEE INC. NEW YORK, vol. 43, no. 9, 1 septembre 1996 (1996-09-01), pages 769-778, XP000631227 ISSN: 1057-7122 * figure 3 * | 1,5 | H03K19/00 |
| A | LIM J ET AL: "REVERSIBLE ENERGY RECOVERY LOGIC CIRCUIT WITHOUT NON-ADIABATIC ENERGY LOSS" ELECTRONICS LETTERS,GB,IEE STEVENAGE, vol. 34, no. 4, 19 février 1998 (1998-02-19), pages 344-346, XP000773765 ISSN: 0013-5194 * figures 1,2 * | 1,5 | |
| | | | **DOMAINES TECHNIQUES RECHERCHES (Int.Cl.7)** |
| A | US 5 521 538 A (DICKINSON ALEXANDER G) 28 mai 1996 (1996-05-28) * le document en entier * | 1,5 | H03K |
| A | US 5 493 240 A (FRANK DAVID J) 20 février 1996 (1996-02-20) * le document en entier * | 1,5 | |

Le présent rapport a été établi pour toutes les revendications

| Lieu de la recherche | Date d'achèvement de la recherche | Examinateur |
|---|---|---|
| LA HAYE | 10 octobre 2000 | Feuer, F |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

................................................................
& : membre de la même famille, document correspondant

EPO FORM 1503 03.82 (P04C02)

EP 1 067 692 A1

ANNEXE AU RAPPORT DE RECHERCHE EUROPEENNE
RELATIF A LA DEMANDE DE BREVET EUROPEEN NO.

EP 00 40 1951

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-10-2000

| Document brevet cité au rapport de recherche | Date de publication | Membre(s) de la famille de brevet(s) | Date de publication |
|---|---|---|---|
| US 5521538 A | 28-05-1996 | CA 2172096 A<br>EP 0735688 A<br>JP 8335873 A | 01-10-1996<br>02-10-1996<br>17-12-1996 |
| US 5493240 A | 20-02-1996 | AUCUN | |